Europäisches Patentamt

European Patent Office

Office européen des brevets

(11) Veröffentlichungsnummer: **0 139 205**
A2

## (12) EUROPÄISCHE PATENTANMELDUNG

(21) Anmeldenummer: **84110782.4**

(22) Anmeldetag: **10.09.84**

(51) Int. Cl.⁴: **H 01 L 23/14**
**H 01 L 21/58**

(30) Priorität: **28.09.83 DE 3335184**

(43) Veröffentlichungstag der Anmeldung:
**02.05.85 Patentblatt 85/18**

(84) Benannte Vertragsstaaten:
**AT BE CH DE FR GB IT LI NL SE**

(71) Anmelder: **Siemens Aktiengesellschaft**
**Berlin und München Wittelsbacherplatz 2**
**D-8000 München 2(DE)**

(72) Erfinder: **Lauterbach, Richard**
**Berchemstrasse 13**
**D-8000 München 21(DE)**

(54) Verfahren zum Herstellen von Halbleiterbausteinen mit einem Metallsubstrat.

(57) Auf eine durch Sandstrahlen aufgerauhte Oberfläche eines Metallsubstrats (2) werden nacheinander durch Plasmaspritzen eine Haftschicht (3) und eine Isolierschicht (4) aus Keramikmaterial aufgebracht. Anschließend wird auf die Isolierschicht (4) eine lötfähige Schicht (5) aufgebracht, auf welche dann mindestens ein integrierter Schaltkreis, insbesondere eine Leistungshalbleiter (1), aufgelötet wird. Die Isolierschicht (4) ermöglicht hierbei einen isolierten Aufbau des integrierten Schaltkreises. Die Dicke der Isolierschicht (4) wird dabei nur nach der gewünschten Spannungsfestigkeit festgelegt, d.h. die Isolierschicht (4) wird so dünn aufgebracht, daß eine gute Ableitung der in dem integrierten Schaltkreis erzeugten Verlustwärme in das Metallsubstrat (2) gewährleistet ist. Die Haftschicht (3) soll ein Ablösen der Isolierschicht (4) bei thermischen Wechselbeanspruchungen verhindern. Deshalb wird für die Haftschicht (3) ein Material verwendet, dessen Wärmeausdehnungskoeffizienten zwischen den Wärmeausdehnungskoeffizienten des Metallsubstrats (2) und des Keramiksubstrats der Isolierschicht (4) liegt. Vorzugsweise wird die Haftschicht (3) aus mehreren Teilschichten derart zusammengesetzt, daß sich ein gradueller Übergang des Wärmeausdehnungskoeffizienten ergibt.

FIG 1

Croydon Printing Company Ltd.

SIEMENS AKTIENGESELLSCHAFT

Berlin und München

Unser Zeichen

VPA 83 P 1743 E

BEZEICHNUNG GEÄNDERT
siehe Titelseite

Verfahren zum Herstellen von Halbleiterbausteinen

Die Erfindung betrifft ein Verfahren zum Herstellen von Halbleiterbausteinen mit mindestens einem integrierten Schaltkreis nach dem Oberbegriff des Anspruchs 1.

Ein derartiges Verfahren zum Herstellen von Halbleiterbausteinen mit mindestens einem Leistungshalbleiter ist aus der EP-A1-0 015 053 bereits bekannt. Bei diesem bekannten Verfahren wird auf eine Oberfläche eines beispielsweise aus Aluminium bestehenden Metallsubstrats zunächst eine dünne Isolierschicht aus Keramikmaterial durch Plasmaspritzen aufgebracht. Anschließend wird auf der Isolierschicht beispielsweise durch Siebdrucken ein Leiterbahnmuster erzeugt, auf welches dann insgesamt drei Leistungshalbleiter aufgelötet werden. Die Anschlüsse auf der Oberfläche der drei Leistungshalbleiter werden dann über Kontaktierungsdrähte mit den zugeordneten Anschlüssen eines ebenfalls auf die Isolierschicht aufgebrachten Keramiksubstrats und mit insgesamt drei nach außen ragenden Anschlußfahnen verbunden. Zur Komplettierung des Halbleiterbausteins wird dann die gesamte Anordnung in Kunstharz eingegossen, aus welchem nur noch die drei Anschlußfahnen herausragen.

Bei dem aus der EP-A1-0 015 053 bekannten Verfahren richtet sich die Dicke der auf das Metallsubstrat aufgebrachten Isolierschicht allein nach der gewünschten Spannungsfestigkeit, d.h., die Isolierschicht kann wesentlich dünner ausgeführt werden, als eine zur isolierten Be-

Klk 1 Kow / 28.9.1983

festigung der integrierten Schaltkreise auf das Metallsubstrat aufgelegte Keramikplatte. Hierdurch ergibt sich
der Vorteil, daß eine sehr gute Wärmeableitung der in dem
integrierten Schaltkreisen erzeugten Verlustwärme in das
Metallsubstrat gewährleistet ist. Als Nachteil hat sich
jedoch herausgestellt, daß die Haftfestigkeit zwischen
einer durch Plasmaspritzen hergestellten Isolierschicht
und dem Metallsubstrat den Anforderungen im Betrieb nicht
genügt und sich die Isolierschicht bereits nach kurzer Betriebsdauer eines Halbleiterbausteins ablösen kann. Mit
dem Abheben bzw. Ablösen der Isolierschicht wird dann der
gesamte Halbleiterbaustein zerstört.

Der Erfindung liegt die Aufgabe zugrunde, ein Verfahren
der eingangs genannten Art so zu verbessern, daß eine
dauerhafte und zuverlässige Haftung zwischen der Isolierschicht und dem Metallsubstrat gewährleistet ist.

Diese Aufgabe wird erfindungsgemäß durch die im kennzeichnenden Teil des Anspruchs 1 angegebenen Merkmale gelöst.

Der Erfindung liegt die Erkenntnis zugrunde, daß die große
Differenz zwischen den Wärmeausdehnungskoeffizienten des
Metallsubstrats und des Keramikmaterials der Isolierschicht
bei thermischen Wechselbeanspruchungen zu einem Ablösen
der Isolierschicht führt und daß dieses Ablösen durch eine
als Zwischenschicht durch Plasmaspritzen aufgebrachte
Haftschicht vermieden werden kann. Für die Haftschicht
wird dabei ein Material verwendet, dessen Wärmeausdehnungskoeffizient zwischen den Wärmeausdehnungskoeffizienten des
Metallsubstrats und des Keramikmaterials der Isolierschicht
liegt, so daß die Haftschicht im Hinblick auf die verschiedenen Wärmeausdehnungen als thermische Ausgleichsschicht
wirkt. Das Aufrauhen der Oberfläche des Metallsubstrats durch Sandstrahlen erzeugt eine vergrößerte und metallisch blanke Oberfläche mit durch die teilweise Zerstörung des Gitteraufbaus bedingten großen Bindungskräften, die eine ausgezeichnete Haftung einer unmittelbar danach durch Plasmaspritzen aufgebrachten Haftschicht gewährleisten. Die Haftfestigkeit der auf die Haftschicht ebenfalls durch Plasmaspritzen aufgebrachten Isolierschicht aus Keramikmaterial ist auch ohne zusäztliche Maßnahmen sehr gut. Insgesamt gesehen vermittelt die Haftschicht somit eine dauerhafte Anbindung der Isolierschicht an das Metallsubstrat und eine gute Ableitung der in einem integrierten Schaltkreis erzeugten Verlustwärme in das Metallsubstrat.

Vorzugsweise wird als Material für die Haftschicht eine Aluminium-Silizium-Legierung oder Kupfer oder eine Kupfer-Aluminium-Legierung oder eine Kupfer-Zinn-Legierung oder eine Kupfer-Glas-Mischung oder Nickel oder eine Nickel-Aluminium-Legierung oder eine Nickel-Aluminium-Molybdän-Legierung oder eine Nickel-Chrom-Legierung oder Molybdän oder Wolfram verwendet. Die genannten Materialien zeichnen sich durch besonders gute Hafteigenschaften aus.

Im Hinblick auf eine gute Haftung und eine gute Wärmeableitung hat es sich auch als besonders günstig erwiesen, wenn die Haftschicht mit einer Dicke zwischen 0,05 mm und 0,1 mm aufgebracht wird.

Bei einer bevorzugten Ausgestaltung des erfindungsgemäßen Verfahrens ist vorgesehen, daß die Haftschicht aus mindestens zwei nacheinander aufgebrachten Teilschichten zusammengesetzt wird und daß die für die Teilschichten verwendeten Materialien derart ausgewählt werden, daß sich in der Haftschicht ein gradueller Übergang zwischen dem Wärmeausdehnungskoeffizienten des Metallsubstrats und dem

0139205

Wärmeausdehnungskoeffizienten des Keramikmaterials der Isolierschicht ergibt. Mit einer derartigen graduellen Anpassung des Wärmeausdehnungskoeffizienten der Haftschicht werden besonders gute Hafteigenschaften bei thermischer Wechselbeanspruchung erzielt. Der graduelle Übergang des Wärmeausdehnungskoeffizienten in der Haftschicht kann auf einfache Weise dadurch erzeugt werden, daß dem Material nacheinander aufgebrachter Teilschichten zunehmende Anteile an Keramikmaterial beigemengt werden. Als Material für die Teilschichten wird dabei vorzugsweise Aluminium oder eine Aluminium-Silizium-Legierung oder Kupfer oder eine Kupfer-Aluminium-Legierung oder eine Kupfer-Zinn-Legierung oder eine Kupfer-Glas-Mischung oder Nickel oder eine Nickel-Aluminium-Legierung oder eine Nickel-Aluminium-Molybdän-Legierung oder eine Nickel-Chrom-Legierung oder Molybdän oder Wolfram oder Zink verwendet, wobei diesem Material in nacheinander aufgebrachten Teilschichten zunehmende Anteile an Aluminiumoxid oder Chromoxid oder Zirkoniumdioxid oder Bariumtitanat beigemengt werden.

Eine optimale Anbindung der Haftschicht an das Metallsubstrat und an die Isolierschicht wird schließlich dadurch erreicht, daß für die zuerst aufgebrachte Teilschicht das Metall verwendet wird, aus welchem das Metallsubstrat besteht, das für die zuletzt aufgebrachte Teilschicht das Keramikmaterial verwendet wird, aus welchem die Isolierschicht besteht und daß für die dazwischenliegenden Teilschichten Mischungen aus dem Metall und dem Keramikmaterial mit zunehmenden Anteilen an Keramikmaterial verwendet werden.

Bei einer aus zwei oder mehreren Teilschichten zusammengesetzten Haftschicht hat es sich als zweckmäßig erwiesen, wenn die Haftschicht mit einer Dicke zwischen 0,3 mm und 0,7 mm aufgebracht wird.

Ausführungsbeispiele der Erfindung sind in der Zeichnung dargestellt und werden im folgenden näher beschrieben. Es zeigen:

Figur 1 einen Schnitt durch einen Halbleiterbaustein mit einem Leistungshalbleiter in stark vereinfachter schematischer Darstellung, die

Figuren 2 bis 5 verschiedene Verfahrensstadien bei der Herstellung des in Figur 1 dargestellten Halbleiterbausteins und

Figur 6 eine Variante mit einer aus insgesamt sechs Teilschichten zusammengesetzten Haftschicht.

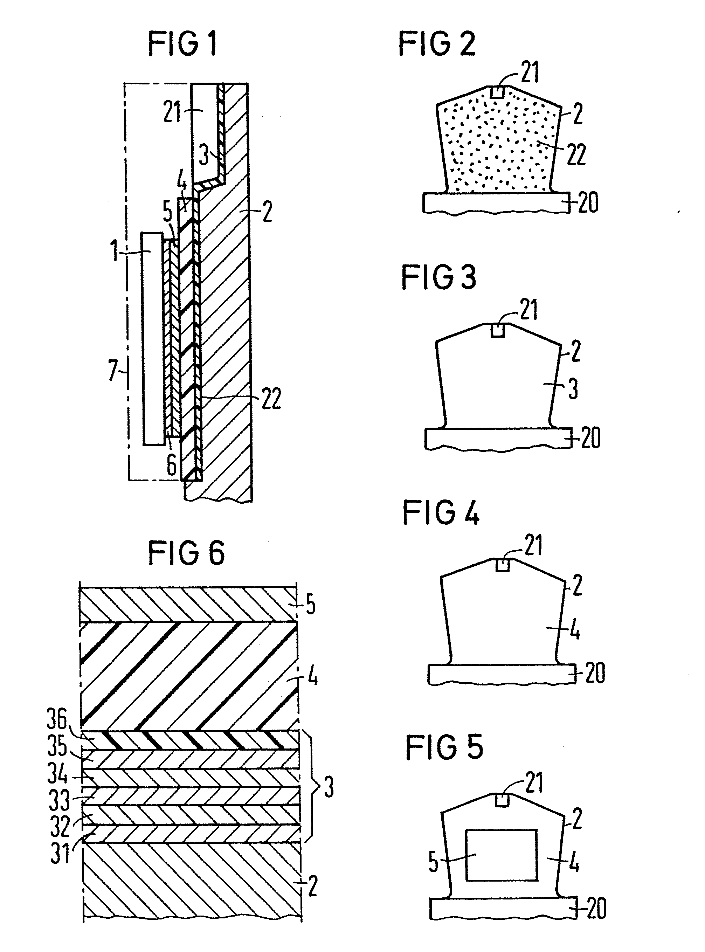

Figur 1 zeigt einen Schnitt durch einen Halbleiterbaustein mit einem Leistungshalbleiter 1, welcher auf einem Metallsubstrat 2 angeordnet ist. Wie zusätzlich aus den Figuren 2 bis 5 zu erkennen ist, besitzt das im wesentlichen plattenförmig ausgebildete Metallsubstrat 2 im unteren Bereich einen flanschartigen Befestigungsfuß 20, während in dem oberen Bereich eine U-förmige Einprägung 21 für die Anordnung einer in der Zeichnung nicht näher dargestellten Anschlußfahne eingebracht ist. Auf einer Oberfläche 22 des Metallsubstrats 2 sind nacheinander eine Haftschicht 3, eine Isolierschicht 4 und eine lötbare Schicht 5 angeordnet, wobei die lötbare Schicht 5 über eine Lotschicht 6 mit der metallisierten Unterseite des Leistungshalbleiters 1 verbunden ist. Nach dem Auflöten des Leistungshalbleiters 1 wird dieser zusammen mit den in der Zeichnung nicht dargestellten Kontaktierungsdrähten und Anschlußfahnen in eine elektrisch isolierende Vergußmasse eingebettet, deren äußere Kontur durch eine strichpunktierte Linie angedeutet ist. Die in dem Leistungshalbleiter 1 erzeugte Verlustwärme wird über die Lotschicht 6, die lötbare Schicht 5, die Isolierschicht 4 und die Haftschicht 3 in das Metallsubstrat 2 abgeleitet. Andererseits ist der Leistungshalbleiter 1 elektrisch isoliert auf dem Metallsubstrat 2 aufgebaut, was durch eine entsprechende Spannungsfestigkeit der aus Keramikmaterial bestehenden Isolierschicht 4 erreicht wird. Durch den isolierten Aufbau können dann mehrere Halbleiterbausteine an einem gemeinsamen metallischen Gehäuse oder dgl. befestigt werden, welches die weitere Wärmeableitung übernimmt.

Bei der Herstellung des in Figur 1 dargstellten Halbleiterbausteins wird zunächst gemäß Figur 2 die Oberfläche 22 des Metallsubstrats 2 durch Sandstrahlen gereinigt und aufgerauht. Solange die durch das Sandstrahlen freigesetzten Bindungskräfte noch wirken, wird dann auf die aufgerauhte Oberfläche 22 gemäß Figur 3 die Haftschicht 3 durch Plasmaspritzen aufgebracht. Für die Haftschicht 3 wird dabei ein Material verwendet, dessen Wärmeausdehnungskoeffizient zwischen den Wärmeausdehnungskoeffizienten des Metallsubstrats 2 und des Keramikmaterials der Isolierschicht 4 liegt. Auf die derart aufgebrachte Haftschicht 3 wird dann gemäß Figur 4 ebenfalls durch Plasmaspritzen die Isolierschicht 4 aufgebracht, deren Dicke nach der gewünschten elektrischen Spannungsfestigkeit festgelegt wird. Gemäß Figur 5 wird anschließend in einem rechteckförmigen Bereich der etwas geringer ist als die Fläche des Leistungshalbleiters 1 die lötbare Schicht 5 durch Plasmaspritzen oder durch autogenes Flammspritzen aufgebracht. Wie bereits erwähnt wurde, wird dann auf diese lötbare Schicht 5 der Leistungshalbleiter 1 mit Hilfe eines geeigneten Lotes aufgelötet.

Figur 6 zeigt eine Variante, bei welcher die in Figur 1 als homogene Schicht dargestellte Haftschicht 3 aus nacheinander durch Plasmaspritzen aufgebrachten Teilschichten 31, 32, 33, 34, 35 und 36 zusammengesetzt wird. Dabei werden die für die Teilschichten 31 bis 36 verwendeten Materialien derart ausgewählt, daß sich in der zusammengesetzten Haftschicht 3 ein gradueller Übergang zwischen dem Wärmeausdehnungskoeffizienten des Metallsubstrats 2 und dem Wärmeausdehnungskoeffizienten des Keramikmaterials der Isolierschicht 4 ergibt. Mit einem derartigen graduellen Übergang des Wärmeausdehnungskoeffizienten werden die verschiedenen Ausdehnungskoeffizienten von Metallsubstrat 2 und Isolierschicht 4 bei thermischen Wechselbeanspruchungen besonders gut ausgeglichen.

Beispiel 1

Die Oberfläche 22 eines Metallsubstrats 2 aus Kupfer wird zunächst durch Sandstrahlen aufgerauht und gereinigt, wobei für das Sandstrahlen Siliziumkarbid mit einer Korngröße von ca. 0,7 mm verwendet wird. Auf die aufgerauhte Oberfläche 22 wird dann eine ca. 0,08 mm dicke Haftschicht 3 aus einer Nickel-Aluminium-Legierung mit 95% Nickel und 5% Aluminium durch Plasmaspritzen aufgebracht. Anschließend wird auf die Haftschicht 3 ebenfalls durch Plasmaspritzen eine ca. 0,5 mm dicke Isolierschicht 4 aus reinem Aluminiumoxid aufgebracht. Auf einen rechteckförmigen Bereich der Isolierschicht 4 wird danach durch Plasmaspritzen eine ca. 0,15 mm dicke lötbare Schicht 5 aus Kupfer aufgebracht. Unter Verwendung eines Lotes LPb 98 Sn wird dann schließlich der Leistungshalbleiter 1 mit seiner metallisierten Unterseite auf die lötbare Schicht 5 aufgelötet.

Beispiel 2

Die Oberfläche 22 eines Metallsubstrats 2 aus Aluminium wird zunächst durch Sandstrahlen aufgerauht und gereinigt, wobei für das Sandstrahlen Siliziumkarbid mit einer Korngröße von ca. 0,7 mm verwendet wird. Auf die aufgerauhte Oberfläche 22 werden dann durch Plasmaspritzen nacheinander jeweils ca. 0,08 mm dicke Teilschichten 31, 32, 33, 34, 35 und 36 aufgebracht, so daß sich für die zusammengesetzte Haftschicht 3 eine Dicke von ungefähr 0,5 mm ergibt. Als Material für die erste Teilschicht 31 wird dabei reines Aluminium verwendet, welches eine optimale Verbindung mit dem ebenfalls aus Aluminium bestehenden Metallsubstrats 2 gewährleistet. Als Materialien für die anschließend aufgebrachten Teilschichten 32, 33, 34 und 35 werden Aluminium-Aluminiumoxid-Mischungen verwendet, wobei die Teilschicht 32 80% Aluminium und 20% Aluminiumoxid, die Teilschicht 33 60% Aluminium und 40% Aluminiumoxid, die Teilschicht 34 40% Aluminium und 60% Aluminiumoxid und die Teilschicht 35 20% Aluminium und 80% Aluminiumoxid enthalten. Für die zuletzt aufgebrachte Teilschicht 36 wird dann reines Aluminiumoxid verwendet. Auf die derart zusammengesetzte Haftschicht 3 wird dann ebenfalls durch Plasmaspritzen eine ca. 0,5 mm dicke Isolierschicht 4 aus reinem Aluminiumoxid aufgebracht, wobei durch die Verwendung des gleichen Materials eine optimale Verbindung mit der darunterliegenden Teilschicht 36 gewährleistet ist. Auf einen rechteckförmigen Bereich der Isolierschicht 4 wird danach durch Plasmaspritzen eine ca. 0,15 mm dicke lötbare Schicht 5 aus Silber aufgebracht, auf welche dann der Halbleiterbaustein 1 unter Verwendung eines Lotes LPb 98Sn aufgelötet wird.

8 Patentansprüche
6 Figuren

Patentansprüche

1. Verfahren zum Herstellen von Halbleiterbausteinen mit mindestens einem integrierten Schaltkreis, bei welchem auf eine Oberfläche eines Metallsubstrats eine dünne Isolierschicht aus Keramikmaterial durch Plasmaspritzen aufgebracht wird, anschließend auf die Isolierschicht eine lötbare Schicht aufgebracht wird und dann der integrierte Schaltkreis auf die lötbare Schicht aufgelötet wird, dadurch gekennzeichnet , daß vor dem Aufbringen der Isolierschicht (4) auf die durch Sandstrahlen aufgerauhte Oberfläche (22) des Metallsubstrats (2) eine Haftschicht (3) durch Plasmaspritzen aufgebracht wird und daß für die Haftschicht (3) ein Material verwendet wird, dessen Wärmeausdehnungskoeffizient zwischen den Wärmeausdehnungskoeffizienten des Metallsubstrats (2) und des Keramikmaterials der Isolierschicht (4) liegt.

2. Verfahren nach Anspruch 1, dadurch gekennzeichnet , daß als Material für die Haftschicht eine Aluminium-Silizium-Legierung oder Kupfer oder eine Kupfer-Aluminium-Legierung oder eine Kupfer-Zinn-Legierung oder eine Kupfer-Glas-Mischung oder Nickel oder eine Nickel-Aluminium-Legierung oder eine Nickel-Aluminium-Molybdän-Legierung oder eine Nickel-Chrom-Legierung oder Molybdän oder Wolfram verwendet wird.

3. Verfahren nach Anspruch 1 oder 2, dadurch gekennzeichnet , daß die Haftschicht (3) mit einer Dicke zwischen 0,05 mm und 0,1 mm aufgebracht wird.

4. Verfahren nach Anspruch 1, dadurch gekennzeichnet , daß die Haftschicht (3) aus mindestens zwei nacheinander aufgebrachten Teilschichten (31, 32, 33, 34, 35 und 36) zusammengesetzt wird und daß die für die Teilschichten (31, 32, 33, 34, 35 und 36) verwendeten Materialien derart ausgewählt werden, daß sich in der Haftschicht (3) ein gradueller Übergang zwischen dem Wärmeausdehnungskoeffizienten des Metallsubstrats (2) und dem Wärmeausdehnungskoeffizienten des Keramikmaterials der Isolierschicht (4) ergibt.

5. Verfahren nach Anspruch 4, dadurch g e k e n n - z e i c h n e t , daß der graduelle Übergang des Wärmeausdehnungskoeffizienten in der Haftschicht (3) dadurch erzeugt wird, daß dem Material nacheinander aufgebrachter Teilschichten (32, 33, 34, 35,) zunehmende Anteile an Keramikmaterial beigemengt werden.

6. Verfahren nach Anspruch 4 oder 5, dadurch g e - k e n n z e i c h n e t , daß als Material für die Teilschichten (31, 32, 33, 34, 35, 36) Aluminium oder eine Aluminium-Silizium-Legierung oder Kupfer oder eine Kupfer-Aluminium-Legierung oder eine Kupfer-Zinn-Legierung oder eine Kupfer-Glas-Mischung oder Nickel oder eine Nickel-Aluminium-Legierung oder eine Nickel-Aluminium-Molybdän-Legierung oder eine Nickel-Chrom-Legierung oder Molybdän oder Wolfram oder Zink verwendet wird, wobei diesem Material in nacheinander aufgebrachten Teilschichten (32, 33, 34, 35) zunehmende Anteile an Aluminiumoxid oder Chromoxid oder Zirkoniumdioxid oder Bariumtitanat beigemengt werden.

7. Verfahren nach einem der Ansprüche 4 bis 6, dadurch g e k e n n z e i c h n e t , daß für die zuerst aufgebrachte Teilschicht (31) das Metall verwendet wird, aus welchem das Metallsubstrat (2) besteht, daß für die zuletzt aufgebrachte Teilschicht (36) das Keramikmaterial verwendet wird, aus welchem die Isolierschicht (4) besteht und daß für die dazwischenliegenden Teilschichten (32, 33, 34, 35) Mischungen aus dem Metall und dem Keramikmaterial mit zunehmenden Anteilen an Keramikmaterial verwendet werden.

8. Verfahren nach einem der Ansprüche 4 bis 7, dadurch g e k e n n z e i c h n e t , daß die Haftschicht (3) mit einer Dicke zwischen 0,3 mm und 0,7 mm aufgebracht wird.

FIG 1

FIG 2

FIG 3

FIG 4

FIG 6

FIG 5